# EUROPEAN PATENT SPECIFICATION

(11) **EP 0 848 248 B1**
(45) Date of publication and mention of the grant of the patent: **17.09.2003**
(21) Application number: 97309931.0
(22) Date of filing: 09.12.1997
(51) Int. Cl.: G12B 21/08, G01N 27/00, G01B 7/34

(54) **Cantilever and method of manufacturing the same**
Freitragender Ausleger und Verfahren zu dessen Herstellung
Cantilever et procédé pour sa fabrication

(30) Priority: 10.12.1996 JP 32987796
(43) Date of publication of application: 17.06.1998
(73) Proprietor: Seiko Instruments Inc., Chiba-shi, Chiba (JP)
(72) Inventor: Shirakawabe, Yoshiharu, Mihama-ku, Chiba-shi, Chiba (JP); Shimizu, Nobuhiro, Mihama-ku, Chiba-shi, Chiba (JP); Takahashi, Hiroshi, Mihama-ku, Chiba-shi, Chiba (JP)
(74) Representative: Sturt, Clifford Mark

(56) References cited:
- EP-A- 0 701 102
- WO-A-92/12398
- WO-A-95/03561
- US-A- 5 336 369
- US-A- 5 367 165
- PATENT ABSTRACTS OF JAPAN vol. 097, no. 008, 29 August 1997 & JP 09 105755 A (OLYMPUS OPTICAL CO LTD), 22 April 1997,
- PATENT ABSTRACTS OF JAPAN vol. 097, no. 003, 31 March 1997 & JP 08 285867 A (HITACHI LTD), 1 November 1996,

## Description

The present invention relates to a cantilever and a method of manufacturing the same, and more particularly to a cantilever and a method of manufacturing the same suitable for a scanning type of probe microscope represented by the AFM (Atomic Force Microscope), and in which a probe, which approaches the surface of a sample to be scanned, is provided at a free edge of the cantilever. A beam section of the cantilever is deflected by force generated between the probe and the surface of the sample. When the surface of a sample placed in a liquid is to be observed, the present invention relates to observation of the surface of the sample with an optical lever reflecting section of the cantilever which is kept above the liquid.

A cantilever with a probe provided at a free edge of a beam section thereof and supported in a cantilever form has been used as a scanning probe in a scanning type of atomic force microscope (AFM). In the cantilever having the configuration as described above, when a surface of a sample is scanned with the probe, an attractive force or a repulsive force according to an interatomic force is generated between the sample surface and the probe. Thus, the form of the sample surface can be measured by detecting the interatomic force as a deflection rate of the cantilever.

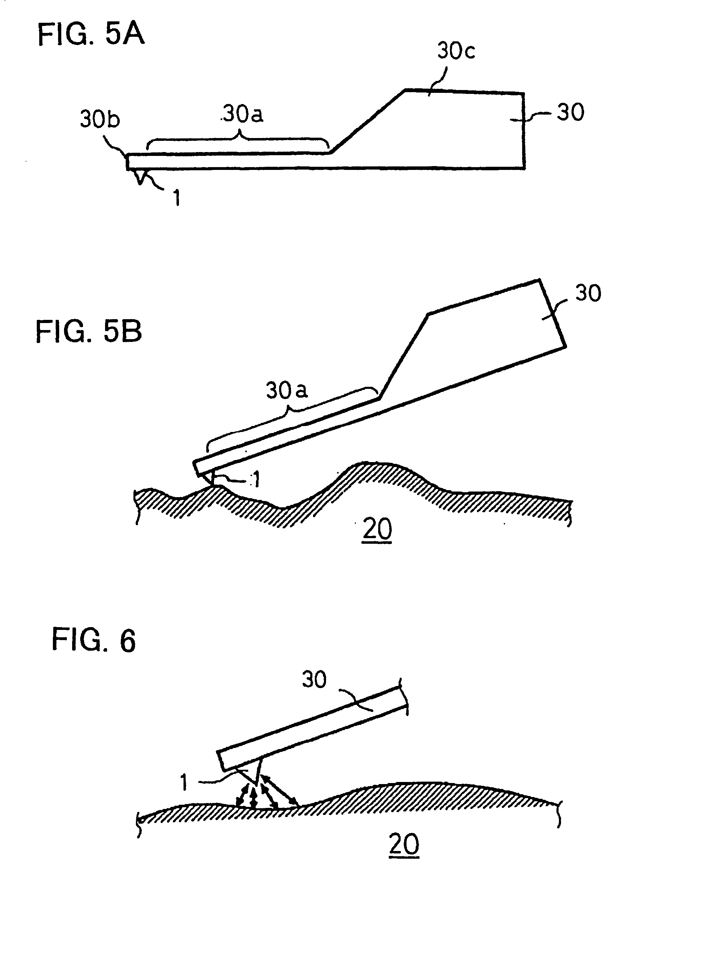

A conventional type of cantilever for an AFM is disclosed in, for instance, Japanese patent Laid-Open Publication No. HEI 5-196458. A conventional cantilever, having an overall linear form, is shown in Fig. 5A hereof. The cantilever has a free edge 30b at which a probe 1 is formed and a fixed edge 30c fixed to the main body of a microscope. The free edge is connected to the fixed edge via the beam section 30a of the cantilever. When the linear cantilever 30 as described above is used for a scanning probe, if the cantilever is arranged in a posture such that the beam section 30a is parallel to the surface of a sample, the beam section 30a may contact the surface of the sample if the sample has a largely wavy surface, whereby the probe 1 cannot accurately trace the surface of the sample. For this reason, the conventional cantilever 30 is attached to the main body of the microscope at an angle, as shown in Fig. 5B. That is, the cantilever is inclined towards the surface of the sample so that the probe 1 can accurately trace the surface thereof without the beam section 30a contacting the sample 20 even if the sample has a largely wavy surface.

When a sample placed in a liquid is to be measured with the conventional type of AFM, the entire cantilever is required to be sunk in the liquid. An optical lever having a lever section which provides a reflecting surface is positioned in the liquid. This makes it difficult to adjust the position of the laser, and the reflecting position can change due to refraction, absorption, or change in the liquid surface, so that reflection intensity becomes weaker and accurate measurement cannot be carried out.

When the cantilever 30 is attached at an angle towards the surface of a sample, the probe 1 approaches the surface of the sample at an angle. Fig. 6 is a simulated view showing the interatomic force when the probe 1 approaches the sample surface at an angle. It is clear that the interatomic force is not uniformly applied to the probe 1 when in the position shown in figure 6. For this reason, a deflection rate of the cantilever 30 cannot accurately represent a distance between the probe 1 and the sample 20, so that sensitivity is reduced and measurement errors become large.

US Patent No. 5367165 discloses a cantilever with a probe at the distal end. An axis of the probe is inclined at a predetermined angle with respect to a normal extending from the surface of the cantilever. This angle is set such that the axis of the probe is perpendicular to a sample surface when the cantilever is mounted on an atomic force microscope.

US Patent No. 5336369 discloses a method of manufacturing a cantilever stylus for an atomic force microscope. A stylus film is formed on a surface of a substrate, then a resist film is formed on the stylus film. The stylus film is etched with isotopic etching to form a tip on one of the principal surfaces. The resist film and substrate are then removed.

When the sample to be measured is in a liquid, the entire cantilever is sunk in the liquid. Laser light for detecting an optical lever is reflected from the liquid surface or is absorbed by the liquid. Also, the reflection intensity of the laser drops or the reflecting position is displaced, which makes it impossible to perform correct or high sensitivity detection.

The present invention was made with a view to mitigating the problems relating to the conventional technology. It is an object of the present invention to provide a cantilever and a method of manufacturing the same in which, even if a probe formed at a free edge vertically approaches a surface of a sample to be scanned thereby, the probe can accurately trace the surface thereof with the main body of the cantilever not contacting the surface and in which accurate observation of a sample in a liquid can be performed, because the laser reflecting surface of the cantilever does not sink in the liquid.

To achieve the objects described above, according to the present invention the following features may be provided in a cantilever with a probe provided at a free edge of a beam section supported in a cantilever form and in a method of manufacturing the same:-
(1) A cantilever carrying the probe of a scanning probe microscope, is provided with a free-end portion which carries the probe, a fixed-end portion which is used to connect the cantilever to the microscope, and a beam portion which interconnects the free-end portion and the fixed-end portion. The beam portion being inclined such that the free-end and fixed-end portions are parallel but non-coplanar with each other. A peripheral section laterally surrounds the cantilever and has a concave section at its centre and an opening in the bottom and the inclined portion of the concave section. The opening has a shape corresponding to the shape of the free-end portion and the beam portion such that the free-end portion and the beam portion of the cantilever are parallel and coplanar to the bottom and the inclined portion of the concave section respectively and separated from the concave section by a gap.
(2) In a method the steps of: providing a substrate having two opposed surfaces and a longitudinal direction; forming two masks on the substrate, longitudinally separated from each other and on respective ones of the opposed surfaces; etching the said opposed surfaces so as to form respective end portions of a cantilever where the respective masks protect the substrate, and a beam portion where the substrate is unprotected by either mask, the beam portion being generally inclined with respect to the said longitudinal direction; anisotropically etching the surface of said substrate to form a peripheral section laterally surrounding the cantilever and having a concave section at its centre, the concave section having an opening in the bottom and inclined portion having a shape corresponding to the shape of the free-end portion and beam portion such that the bottom and inclined portion of the concave section are parallel and coplanar with the free-end portion and beam portion respectively; setting a gap between the free-end portion and beam portion of the cantilever and the bottom and inclined portion of the concave section of the peripheral section to a width in the range of 1µm to 100µm; undercut etching a mask on one of the said end portions so as to form the probe carried by the cantilever.

With the cantilever having the configuration (1) as described above, even if the probe has vertically approached a surface of a sample, contact between the main body of the cantilever and the surface of the sample can be avoided, which allows the probe to accurately trace the surface of the sample. With the method of manufacturing the cantilever according to the configuration (2) as described above, a non-linear cantilever having a bend section(s) can be formed by chemical etching steps only without requiring complicated polishing steps which are required in mechanical processing methods.

As the entire cantilever is not required to be sunk in a liquid when a sample in the liquid is to be observed, accurate observation of a sample in a liquid can be performed because attenuation of laser light for detecting a position due to reflection on the surface of the liquid or absorption thereby does not occur or displacement of the laser light does not also occur more than the displacement due to interaction between the probe and the sample due to its irregular reflection.

Embodiments of the invention will now be described in more detail, by way of example only and with reference to the accompanying drawings, in which:-
Fig. 1 is a side view of a cantilever as an example useful for understanding the invention.
Fig. 2 is a simulated view showing actions of an interatomic force when a probe has vertically approached the surface of the sample as an example useful for understanding the invention.
Fig. 3A-3C are views (Part one) showing a method of manufacturing a non-linear cantilever as an example useful for understanding the invention.
Fig. 4A-4B are views (Part two) showing a method of manufacturing a non-linear cantilever as an example useful for understanding the invention.
Fig. 5A-5B are views showing a structure of the linear cantilever based on the conventional technology and usage thereof.
Fig. 6 is a view for explaining the problems of the linear cantilever based on the conventional technology.
Fig. 7A-7B are a side view and a plane view of a cantilever for observation of a sample in a liquid according to one embodiment of the present invention.

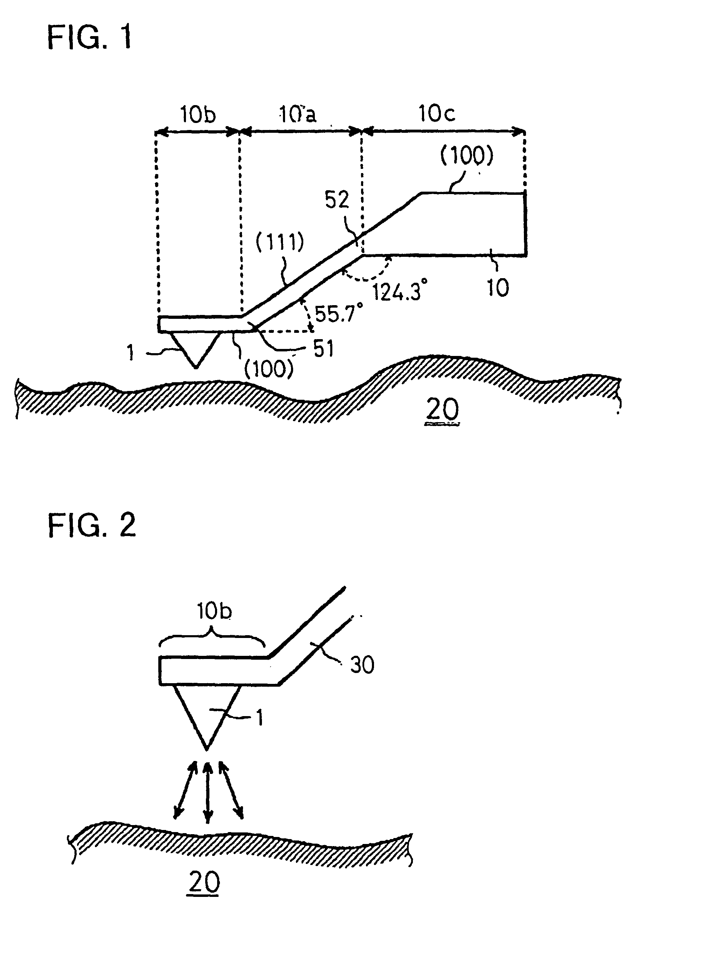

Fig. 1 is a side view of a cantilever as an example useful for understanding the invention and in the other figures the same reference numerals are assigned to the sections identical or corresponding to those in Fig. 1.

A cantilever 10 is constructed by subjecting a silicon substrate to etching, and has three portions with bend sections 51 and 52 as respective boundaries therebetween. The three portions are; supporting section 10b in the side of a free edge, a beam section 10a, and a supporting section 10c in the side of a fixed edge. A probe 1 is formed in the free edge side supporting section 10b and the fixed edge side supporting section 10c is fixed to a main body of a microscope. The angle between free edge side supporting section 10b and the beam section 10a is about 55.7° at the bend section 51. The angle between the beam section 10a and the fixed edge side supporting section 10c is about 124.3° at the bend section 52. The free edge side supporting section 10b and the fixed edge side supporting section 10c are not in the same plane as each other but are parallel to each other. The <100> plane is exposed on each surface of the supporting sections. The <111> plane is exposed on the surface of the beam section 10a. With the non-linear cantilever as described above, the probe 1 can vertically approach a surface of a sample without the beam section 10a contacting the surface of the sample even if the sample has a comparatively large wavy surface. Fig. 2 is a simulated view showing actions of interatomic force when the probe 1 vertically approaches the surface of the sample. The interatomic force is uniformly applied to the probe 1 in the posture shown in the figure, so that the deflection rate of the cantilever 30 can accurately represent the distance between the probe 1 and the sample 20.

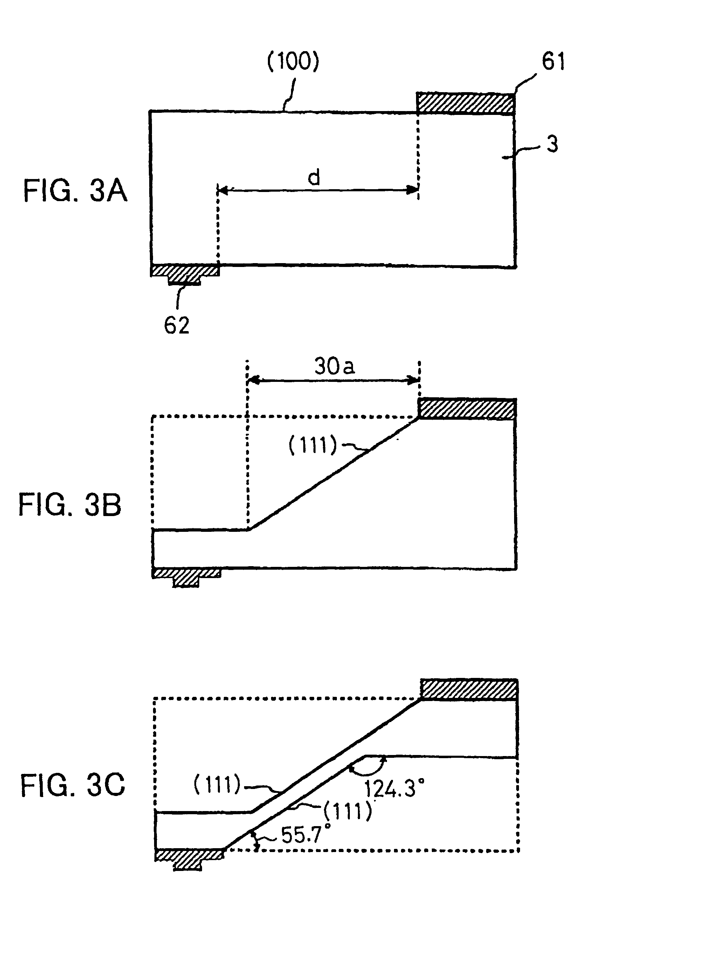

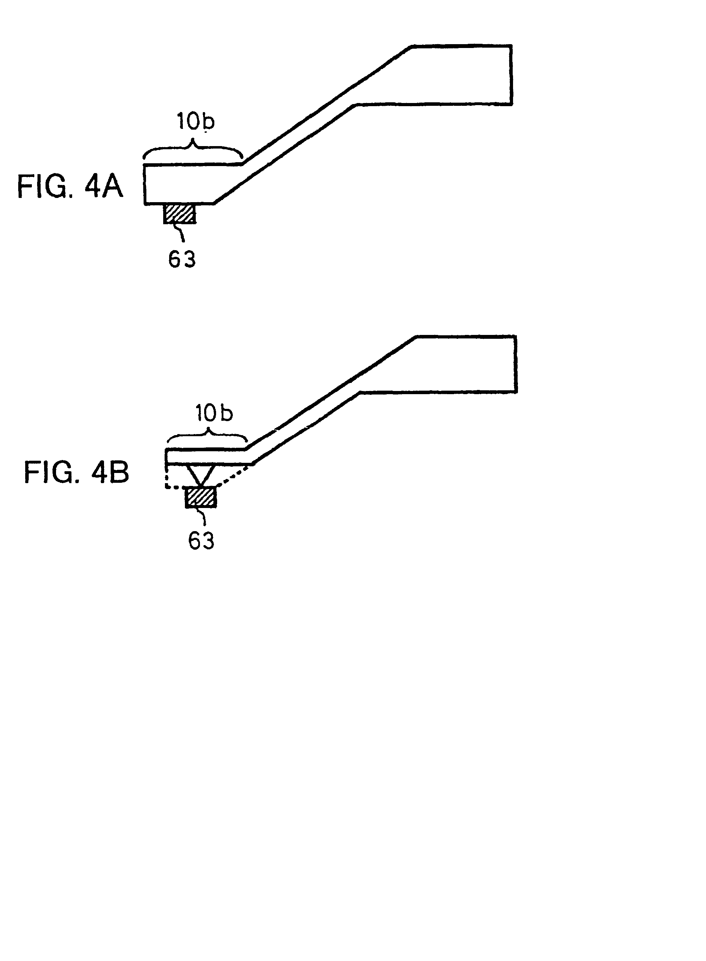

Fig. 3A-3C and Fig. 4A-4B are cross-sectional views each showing a method of manufacturing the non-linear cantilever having two bend sections as described above. The same reference numerals are assigned to sections identical or corresponding to those in the previous figures. First, masks 61, 62 such as an oxide film are formed at one edge of the top surface of a silicon substrate 3 as well as at the opposite edge of the bottom or rear surface of the substrate. The masks are formed on respective <100> planes of the substrate. (Refer to Fig. 3A). The masks 61, 62 are arranged with a specified spacing d provided therebetween in the horizontal direction, so that projections from the mask sections would not superimpose on each other. The spacing or gap d in this case is decided according to the crystal structure of the material of the substrate (silicon in this embodiment), the thickness of the substrate, and the thickness of the beam section 30a or the like.

Next, the top surface of the silicon substrate 3 is subjected to anisotropic wet etching to a specified depth using the mask 61 to prevent etching at the respective edge. (Refer to Fig. 3B). As a solvent for etching, use can be made of a 40 percent by weight aqueous solution of potassium hydroxide (KoH) at a temperature in a range from 60° C to 80° C and a 20 percent by weight aqueous solution of tetramethylammonium hydroxide (TMAH) at a temperature in a range from 80° C to 90° C or the like. With these types of solvent for etching, the <100> plane is subjected to etching much quicker than the <111> plane. Thus, the mask 61 is in practice not affected by etching. Accordingly, this anisotropic etching is in practice stopped at the <111> plane with the edge section of the mask 61 as a reference. The <111> plane is exposed in a gap area which forms the beam section 30a.

When a rear surface of the silicon substrate is also subjected to anisotropic wet etching in the same manner as used for the top surface; the <111> plane with the edge section of the mask 62 as a reference is exposed in the gap area (Refer to Fig. 3C). When a silicon substrate 3 is used as in this embodiment, there is generated an angle of around 55.7° (around 124.3°) between the <100> plane and the <111> plane.

Next, a mask 63 is formed on the surface of the free edge side supporting section 10b (Refer to Fig. 4A). A probe 1 is formed by under-cutting the silicon under the mask 63 with dry etching according to the height of the probe 1 (Refer to Fig. 4B). Finally, the mask 63 is removed and the cantilever 10 is completed.

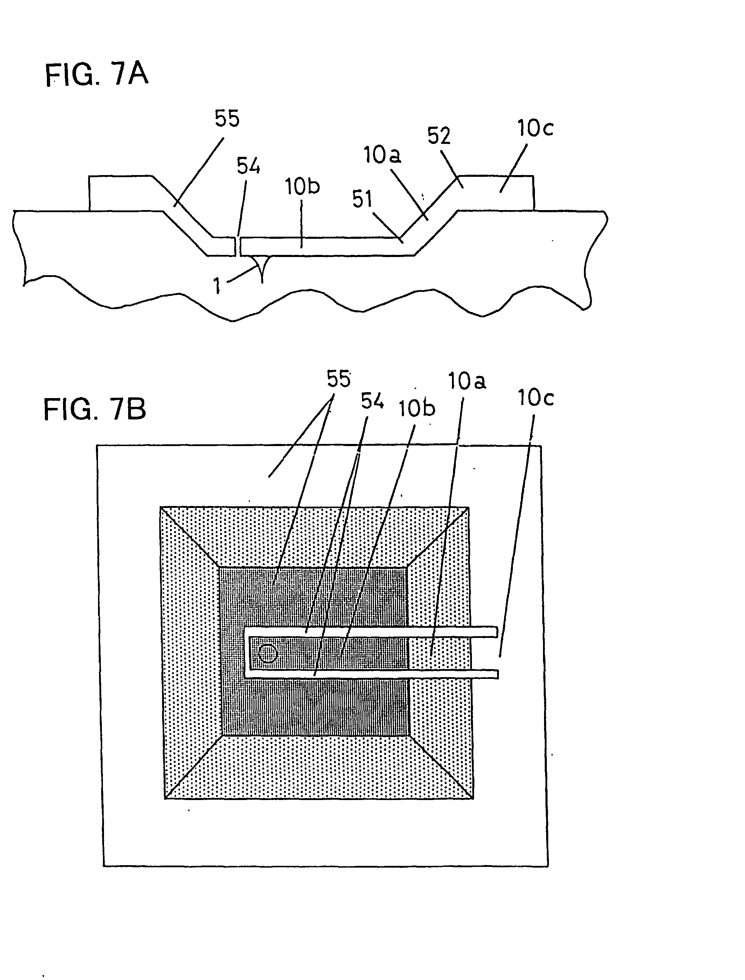

With this embodiment of the present invention, a non-linear cantilever having bend sections can be formed by wet type and/or dry type of etching steps only without requiring complicated polishing steps which are required in mechanical processing methods. Fig. 7A and 7B show a cantilever according to an embodiment of the present invention and having a form effective for observation of a sample in a liquid.

Observation of a surface of a sample in a liquid can be performed by sinking only the probe 1 in the liquid, as shown in Fig. 7A, while penetration of water is evaded due to surface tension by providing a peripheral section of the cantilever shown in Fig. 1 of a concave form and making a gap 54 between the cantilever and the peripheral section thereof as small as around 1 to 100 µ m.

It should be noted that description of the above embodiment assumes that a cantilever is formed by subjecting a silicon substrate to etching, but the present invention is not limited only to the silicon substrate. The same type of cantilever can be made also by etching a crystal or a gallium arsenide substrate.

With the present invention, the effects described below can be achieved:-
(1) Bending sections are provided between a free edge with a probe provided thereon and a fixed edge. A beam section is inclined by a specified angle towards a surface of a sample in a state where the probe vertically approaches the surface of the sample. Thus, even if the probe has vertically approached the surface thereof, contact between the main body of the cantilever and the surface of the sample can be avoided. This allows the probe accurately to trace the surface of the sample.
(2) A non-linear cantilever having bend sections can be formed by wet type and/or dry type of etching steps only without requiring complicated polishing steps which are required in mechanical processing methods.
(3) An object in a liquid can be observed simply by sinking only the probe in the liquid with the cantilever as a whole kept above the liquid.

The aforegoing description has been given by way of example only and it will be appreciated by a person skilled in the art that modifications can be made without departing from the scope of the present invention.

## Claims

1. A cantilever (10) carrying the probe (1) of a scanning probe microscope, the cantilever comprising a free-end portion (10b) which carries the probe (1), a fixed-end portion (10c) which is used to connect the cantilever to the microscope, and a beam portion (10a) which interconnects the free-end portion (10b) and the fixed-end portion (10c), the beam portion (10a) being inclined such that the free-end and fixed-end portions (10b, 10c) are parallel but non-coplanar with each other, **characterised by** a peripheral section (55) laterally surrounding the cantilever and having a concave section at its centre, an opening being in the bottom and the inclined portion of the concave section, the opening having a shape corresponding to the shape of the free-end portion (10b) and the beam portion (10a) such that the free-end portion (10b) and the beam portion (10a) of the cantilever are parallel and coplanar to the bottom and the inclined portion of the concave section respectively and separated from the concave section by a gap (54).

2. A cantilever (10) as claimed in claim 1, wherein the gap (54) has a width in the range of 1 µm to 100 µm.

3. Use of a scanning probe microscope in observing the surface of an object covered by a liquid, the microscope having a cantilever (10) as claimed in claim 1 or 2 and the peripheral section (55) thereof remaining above the surface of the liquid during scanning.

4. A cantilever (10) as claimed in claim 1, **characterised in that** the said portions (10a, lOb, 10c) and the probe (1) are all formed as a single, unitary body.

5. A cantilever (10) as claimed in claim 1 or claim 4, wherein said cantilever (10) is formed from a semiconductor substrate, the surfaces of said beam portion (10a) being a <111> plane, and each surface of said fixed end portion (10c) and said free end portion (10b) being a <100> plane.

6. A method of manufacturing a cantilever (10) which carries the probe (1) of a scanning probe microscope as claimed in any one of claims 1 - 5, comprising the steps of:
providing a substrate (3) having two opposed surfaces and a longitudinal direction,
forming two masks (61, 62) on the substrate (3), longitudinally separated from each other and on respective ones of the opposed surfaces,
etching the said opposed surfaces so as to form respective end portions (10b, 10c) of a cantilever (10) where the respective masks (61, 62) protect the substrate (3), and a beam portion (10a) where the substrate (3) is unprotected by either mask (61,62), the beam portion (10a) being generally inclined with respect to the said longitudinal direction,
anisotropically etching the surface of said substrate (3) to form a peripheral section (55) laterally surrounding the cantilever (10) and having a concave section at its centre, the concave section having an opening in the bottom and inclined portion having a shape corresponding to the shape of the free-end portion (10b) and beam portion (10a) such that the bottom and inclined portion of the concave section are parallel and coplanar with the free-end portion (10b) and beam portion (10a) respectively,
setting a gap between the free-end portion (10b) and beam portion (10a) of the cantilever (10) and the bottom and inclined portion of the concave section of the peripheral section (55) to a width in the range of 1µm to 100µm,
undercut etching a mask (63) on one of the said end portions (10b) so as to form the probe (1) carried by the cantilever (10).

7. A method as claimed in claim 6, wherein said first-mentioned etching step comprises anisotropic etching.

8. A method as claimed in claim 6, wherein said substrate (3) is a semiconductor substrate, the said opposed surfaces are in <100> planes and the plane <100> is subjected to etching quicker than the plane <111> in the said etching step.

9. A scanning probe microscope **characterised by** a cantilever (10) as claimed in any one of claims 1, 2, 4 and 5.

## Patentansprüche

1. Ausleger (10), der den Fühler (1) eines Abtastfühlermikroskops trägt, wobei der Ausleger umfaßt: einen freien Endabschnitt (10b), der den Fühler (1) trägt, einen festen Endabschnitt (10c), der verwendet wird, um den Ausleger mit dem Mikroskop zu verbinden, und einen Balkenabschnitt (10a), der den freien Endabschnitt (10b) und den festen Endabschnitt (10c) verbindet; wobei der Balkenabschnitt (10a) so geneigt ist, daß die freien und festen Endabschnitte (10b, 10c) parallel, jedoch nicht koplanar miteinander sind, **gekennzeichnet durch** einen Randabschnitt (55), der den Ausleger lateral umgibt und einen konkaven Abschnitt in seiner Mitte aufweist, und wobei eine Öffnung im Boden und im geneigten Abschnitt des konkaven Abschnitts angeordnet ist, die eine der Form des freien Endabschnitts (10b) und des Balkenabschnitts (10a) entsprechende Form aufweist, so daß der freie Endabschnitt (10b) und der Balkenabschnitt (10a) des Auslegers parallel und koplanar zum Boden bzw. zum geneigten Abschnitt des konkaven Abschnitts sind und vom konkaven Abschnitt **durch** einen Spalt (54) getrennt sind.

2. Ausleger (10) nach Anspruch 1, bei dem der Spalt (54) eine Breite im Bereich von 1 µm bis 100 µm aufweist.

3. Verwendung eines Abtastfühlermikroskops bei der Beobachtung der Oberfläche eines Objekts, das durch eine Flüssigkeit bedeckt ist, wobei das Mikroskop einen Ausleger (10) nach Anspruch 1 oder 2 aufweist und dessen Randabschnitt (55) während des Abtastens über der Oberfläche der Flüssigkeit verbleibt.

4. Ausleger (10) nach Anspruch 1, **dadurch gekennzeichnet, daß** die Abschnitte (10a, 10b, 10c) und der Fühler (1) alle in Form eines einzelnen, einheitlichen Körper ausgebildet sind.

5. Ausleger (10) nach Anspruch 1 oder Anspruch 4, bei dem der Ausleger (10) aus einem Halbleitersubstrat gebildet ist, wobei die Oberflächen des Balkenabschnitts (10a) eine <111>-Ebene sind und jede Oberfläche des festen Endabschnitts (10c) und des freien Endabschnitts (10b) eine <100>-Ebene ist.

6. Verfahren zur Herstellung eines Auslegers (10), der den Fühler (1) eines Abtastfühlermikroskops trägt, wie in irgendeinen der Ansprüche 1 bis 5 beansprucht ist, das die Schritte umfaßt:
Bereitstellen eines Substrats (3) mit zwei gegenüberliegenden Oberflächen und einer Longitudinalrichtung,
Ausbilden zweier Masken (61, 62) auf dem Substrat (3) longitudinal getrennt voneinander und auf den jeweiligen gegenüberliegenden Oberflächen,
Ätzen der gegenüberliegenden Oberflächen, um jeweilige Endabschnitte (10b, 10c) eines Auslegers (10) dort auszubilden, wo die jeweiligen Masken (61, 62) das Substrat (3) schützen, und um einen Balkenabschnitt (10a) dort auszubilden, wo das Substrat (3) durch keine der Masken (61, 62) geschützt ist, wobei der Balkenabschnitt (10a) im wesentlichen bezüglich der Longitudinalrichtung geneigt ist,
anisotropes Ätzen der Oberfläche des Substrats (3), um einen Randabschnitt (55) auszubilden, der den Ausleger (10) lateral umgibt und einen konkaven Abschnitt in seiner Mitte aufweist, wobei der konkave Abschnitt eine Öffnung im Boden und im geneigten Abschnitt mit einer Form aufweist, die der Form des freien Endabschnitts (10b) und des Balkenabschnitts (10a) entspricht, so daß der Boden und der geneigte Abschnitt des konkaven Abschnitts parallel und koplanar mit dem freien Endabschnitt 10b bzw. dem Balkenabschnitt (10a) sind,
Einstellen eines Spalts zwischen dem freien Endabschnitt (10b) und dem Balkenabschnitt (10a) des Auslegers (10) und dem Boden und dem geneigten Abschnitt des konkaven Abschnitts des Randabschnitts (55) auf eine Breite im Bereich von 1 µm bis 100 µm,
Unterschnittätzen einer Maske (63) auf einem der Endabschnitte (10b), um somit den Fühler (1) auszubilden, der vom Ausleger (10) getragen wird.

7. Verfahren nach Anspruch 6, bei dem der zuerst erwähnte Ätzschritt ein anisotropes Ätzen umfaßt.

8. Verfahren nach Anspruch 6, bei dem das Substrat (3) ein Halbleitersubstrat ist, wobei die gegenüberliegenden Oberflächen in den <100>-Ebenen liegen und im Ätzschritt die Ebene <100> dem Ätzen schneller unterliegt als die Ebene <111>.

9. Abtastfühlermikroskop, **gekennzeichnet durch** einen Ausleger (10), wie **durch** irgendeinen der Ansprüche 1, 2, 4 und 5 beansprucht ist.

## Revendications

1. Levier (10) portant la sonde (1) d'un microscope-sonde à balayage, le levier comprenant une partie d'extrémité libre (10b) qui porte la sonde (1), une partie d'extrémité fixe (10c) qui est utilisée pour relier le levier au microscope et une partie de tige (10a) qui relie la partie d'extrémité libre (10b) et la partie d'extrémité fixe (10c), la partie de tige (10a) étant inclinée de telle manière que les parties d'extrémité libre et d'extrémité fixe (10b, 10c) sont parallèles mais non coplanaires l'une par rapport à l'autre, **caractérisé par** une section périphérique (55) entourant latéralement le levier et ayant une section concave en son centre, une ouverture étant formée dans le fond et dans la partie inclinée de la section concave, l'ouverture ayant une forme correspondant à la forme de la partie d'extrémité libre (10b) et de la partie de tige (10a) de telle façon que la partie d'extrémité libre (10b) et la partie de tige (10a) du levier sont parallèles et coplanaires au fond et à la partie inclinée de la section concave, respectivement, et séparées de la section concave par un intervalle (54).

2. Levier (10) selon la revendication 1, dans lequel l'intervalle (54) a une largeur comprise entre 1 µm et 100 µm.

3. Utilisation d'un microscope-sonde à balayage pour observer la surface d'un objet recouverte de liquide, le microscope ayant un levier (10) selon la revendication 1 ou 2 et la section périphérique (55) de celui-ci restant au-dessus de la surface du liquide pendant le balayage.

4. Levier (10) selon la revendication 1, **caractérisé en ce que** lesdites parties (10a, 10b, 10c) et la sonde (1) sont toutes formées en un corps d'un seul tenant.

5. Levier (10) selon la revendication 1 ou la revendication 4, dans lequel ledit levier (10) est formé à partir d'un substrat semi-conducteur, les surfaces de ladite partie de tige (10a) formant un plan <111> et chaque surface de ladite partie d'extrémité fixe (10c) et de ladite partie d'extrémité libre (10b) formant un plan <100>.

6. Procédé de fabrication d'un levier (10) qui porte la sonde (1) d'un microscope-sonde à balayage selon l'une quelconque des revendications 1 à 5, comprenant les étapes consistant à :
préparer un substrat (3) ayant deux surfaces opposées et une orientation longitudinale,
former deux masques (61, 62) sur le substrat (3), séparés longitudinalement l'un de l'autre et sur une surface respective des surfaces opposées,
graver lesdites surfaces opposées de façon à former les parties d'extrémité respectives (10b, 10c) d'un levier (10) dans lesquelles les masques respectifs (61, 62) protègent le substrat (3) et une partie de tige (10a) dans laquelle le substrat (3) n'est pas protégé par l'un ou l'autre masque (61, 62), la partie de tige (10a) étant globalement inclinée par rapport à ladite direction longitudinale,
graver par gravure anisotrope la surface dudit substrat (3) de façon à former une section périphérique (55) entourant latéralement le levier (10) et ayant une section concave en son centre, la section concave ayant une ouverture dans le fond et dans la partie inclinée possédant une forme correspondant à la forme de la partie d'extrémité libre (10b) et de la partie de tige (10a), de telle sorte que le fond et la partie inclinée de la section concave sont parallèles et coplanaires à la partie d'extrémité libre (10b) et à la partie de tige (10a) respectivement,
définir un intervalle entre la partie d'extrémité libre (10b) et la partie de tige (10a) du levier (10) et le fond et la partie inclinée de la section concave de la section périphérique (55) à une largeur comprise entre 1 µm et 100 µm,
graver par gravure sous-jacente un masque (63) sur une desdites parties d'extrémité (10b) de façon à former la sonde (1) portée par le levier (10).

7. Procédé selon la revendication 6, dans lequel ladite étape de gravure mentionnée en premier comprend une gravure anisotrope.

8. Procédé selon la revendication 6, dans lequel ledit substrat (3) est un substrat semi-conducteur, lesdites surfaces opposées se situent dans le plan <100> et le plan <100> est soumis au processus de gravure plus rapidement que le plan <111> lors de ladite étape de gravure.

9. Microscope-sonde à balayage **caractérisé par** un levier (10) selon l'une quelconque des revendications 1, 2, 4 et 5.
